# EUROPEAN PATENT APPLICATION

(11) **EP 4 577 014 A1**
(43) Date of publication of application: **25.06.2025**
(21) Application number: 23854789.7
(22) Date of filing: 31.07.2023
(51) Int. Cl.: H10K 30/60, H10K 30/40, H10K 85/40, H10K 85/50

(54) **PHOTOELECTRIC CONVERSION ELEMENT, PHOTOELECTRIC CONVERSION DEVICE, LIGHT DETECTION METHOD, AND METHOD FOR PRODUCING PHOTOELECTRIC CONVERSION ELEMENT**

(30) Priority: 19.08.2022 JP 2022130971
(71) Applicant: Japan Science and Technology Agency, Kawaguchi-shi, Saitama 332-0012 (JP)
(72) Inventor: NIHEI, Ayumi, Tokyo 169-8555 (JP)
(74) Representative: Gilani, Anwar
(86) International application number: PCT/JP2023/027969
(87) International publication number: WO 2024/038754

(57) **Abstract**

A photoelectric conversion element includes, in the following order as a photoelectric conversion layer, a first layer formed of a plurality of particles containing a perovskite structure as a main component, or an aggregate of the particles or a thin film containing a perovskite structure the a main component, a second layer formed of a plurality of particles containing an inorganic transition metal as a main component, or an aggregate of the particles or a thin film containing the inorganic transition metal as a main component, and a third layer formed of a plurality of particles containing an organic ligand as a main component, or an aggregate of the particles or a thin film containing the organic ligand as a main component, in which the inorganic transition metal in the second layer is different from a central metal contained in the perovskite structure, at an interface between the first layer and the second layer, the perovskite structure and the inorganic transition metal in the second layer form a one-to-one layer arrangement, and at an interface between the second layer and the third layer, the inorganic transition metal in the second layer and the organic ligand in the third layer are combined to form an organometallic complex layer made of an organometallic complex.

## Description

### [Technical Field]

The present invention relates to a photoelectric conversion element, a photoelectric conversion device, a light detection method, and a method for producing a photoelectric conversion element.

The present application claims priority based on Japanese Patent Application No. 2022-130971 filed in Japan on August 19, 2022, the contents of which are incorporated herein by reference.

### [Background Art]

A technique for amplifying a photocurrent using a photoelectric conversion element such as an avalanche photodiode or a photomultiplier tube is known. An avalanche photodiode is a photodiode that emits light between pn junctions made of an inorganic semiconductor in a state where a reverse voltage is applied, thereby repeating collision of generated electrons/holes with a crystal lattice and generation of electrons/holes from the collided crystal lattice in a chain manner, and amplifying a photocurrent. The photomultiplier tube includes a plurality of dynodes and a vacuum tube containing the dynodes, and irradiates one dynode with light, thereby repeating collision of generated electrons with the dynode and generation of electrons from the collided dynode in a chain manner, and amplifying a photocurrent.

Patent Document 1 discloses a photoelectric conversion element in which a first layer formed of a plurality of particles containing an inorganic semiconductor as a main component or an aggregate or a thin film thereof, and for a surface of the particles or the aggregate thereof, a second layer formed of a plurality of particles containing a perovskite structure as a main component or an aggregate or a thin film thereof, and a third layer formed of a plurality of particles containing an organometallic complex as a main component or an aggregate or a thin film thereof are sequentially laminated, and in a conduction band, an energy level of the second layer is higher than an energy level of the first layer, an energy level of the third layer is higher than an energy level of the second layer, and in a valence band an energy level of the second layer is higher than an energy level of the third layer.

### [Citation List]

### [Patent Document]

[Patent Document 1]
PCT International Publication No. WO 2020/162317

### [Summary of Invention]

### [Technical Problem]

A photoelectric conversion element having high efficiency and high sensitivity to a weak optical signal while reducing its environmental load, and having more excellent responsiveness than the photoelectric conversion element of Patent Document 1 has been desired.

The present invention has been made in view of the above circumstances, and an object of the present invention is to provide a photoelectric conversion element having high efficiency and high sensitivity to a weak optical signal while reducing its environmental load, and having more excellent responsiveness, a photoelectric conversion device, a light detection method, and a method for producing a photoelectric conversion element.

### [Solution to Problem]

In order to solve the above problems, the present invention proposes the following means.
(1) A photoelectric conversion element according to a first aspect of the present invention includes, in the following order as a photoelectric conversion layer:
   a first layer formed of a plurality of particles containing a perovskite structure as a main component, or an aggregate of the particles or a thin film containing the perovskite structure as a main component;
   a second layer formed of a plurality of particles containing an inorganic transition metal as a main component, or an aggregate of the particles or a thin film containing the inorganic transition metal as a main component;
   and a third layer formed of a plurality of particles containing an organic ligand as a main component, or an aggregate of the particles or a thin film containing the organic ligand as a main component, in which
   the inorganic transition metal in the second layer is different from a central metal contained in the perovskite structure,
   at an interface between the first layer and the second layer, the perovskite structure and the inorganic transition metal in the second layer form a one-to-one layer arrangement, and
   at an interface between the second layer and the third layer, the inorganic transition metal in the second layer and the organic ligand in the third layer are combined to form an organometallic complex layer made of an organometallic complex.
(2) According to a second aspect of the present invention, in the photoelectric conversion element according to the first aspect,
   in a conduction band, an energy level of LUMO of the conduction band of the organometallic complex layer may be higher than an energy level of the conduction band of the first layer, and
   in a valence band, an energy level of the valence band of the first layer may be higher than an energy level of HOMO of the valence band of the organometallic complex layer.
(3) According to a third aspect of the present invention, in the photoelectric conversion element according to the first or second aspect, the second layer may be a layer formed by segregating the inorganic transition metal at a surface of the first layer.
(4) According to a fourth aspect of the present invention, in the photoelectric conversion element according to any one of the first to third aspects, the second layer may be a monatomic layer of the inorganic transition metal.
(5) According to a fifth aspect of the present invention, in the photoelectric conversion element according to any one of the first to fourth aspects, the organic ligand may be α-methylbenzylamine or terpyridine.
(6) According to a sixth aspect of the present invention, in the photoelectric conversion element according to any one of the first to fifth aspects, the central metal contained in the perovskite structure may be lead, the inorganic transition metal in the second layer may be europium, the inorganic transition metal in the second layer forming the organometallic complex may be europium, and the organic ligand forming the organometallic complex may be α-methylbenzylamine or terpyridine.
(7) According to a seventh aspect of the present invention, in the photoelectric conversion element according to any one of the first to sixth aspects, the perovskite structure may be a compound represented by formula CH₃NH₃PbI₃.
(8) A photoelectric conversion device according to an eighth aspect of the present invention includes a photoelectric conversion element, in which, in the photoelectric conversion element according to the first aspect,
   a negative electrode layer is laminated on a side opposite to the second layer with the first layer interposed therebetween, and
   a positive electrode layer is laminated on a side opposite to the second layer with the third layer interposed therebetween.
(9) A light detection method according to a ninth aspect of the present invention includes steps of:
   allowing the photoelectric conversion layer to receive visible light and/or near-infrared light to cause a current to flow between the negative electrode layer and the positive electrode layer in the photoelectric conversion device according to the eighth aspect; and
   measuring the current to detect the visible light and/or the near-infrared light.
(10) A method for producing a photoelectric conversion element according to a tenth aspect of the present invention includes:
   a first step of coating a surface of a base material with a mixture containing a raw material of a perovskite structure and an inorganic transition metal that is contained in the raw material of the perovskite structure and is different from a central metal contained in the perovskite structure;
   a second step of forming a first layer formed of a plurality of particles containing the perovskite structure as a main component or an aggregate of the particles or a thin film containing the perovskite structure as a main component and a second layer formed of a plurality of particles containing the inorganic transition metal as a main component or an aggregate of the particles or a thin film containing the inorganic transition metal as a main component by forming a one-to-one layer arrangement between the perovskite structure and the inorganic transition metal after the first step; and
   a third step of forming an organometallic complex layer made of an organometallic complex by bonding an organic ligand to the inorganic transition metal through a coordinate bond at a second surface, which is opposite to a surface in contact with the first layer, of the second layer after the second step.
(11) According to an eleventh aspect of the present invention, in the method for producing a photoelectric conversion element according to the tenth aspect,
   in a conduction band, an energy level of LUMO of the organometallic complex layer may be higher than an energy level of the conduction band of the first layer, and
   in a valence band, an energy level of the valence band of the first layer may be higher than an energy level of HOMO of the organometallic complex layer.
(12) According to a twelfth aspect of the present invention, in the method for producing a photoelectric conversion element according to the tenth or eleventh aspect,
   in the second step, the second layer may be formed at a surface of the first layer by segregating the inorganic transition metal.
(13) According to a thirteenth aspect of the present invention, in the method for producing a photoelectric conversion element according to any one of the tenth to twelfth aspects, the second layer may be a monatomic layer of the inorganic transition metal.
(14) A method for producing a photoelectric conversion element according to a fourteenth aspect of the present invention includes:
   a mixing step of mixing a raw material of a perovskite structure with an inorganic transition metal that is contained in the raw material of the perovskite structure and is different from a central metal contained in the perovskite structure to obtain a mixture;
   a coating step of coating a surface of a base material with the mixture to form a coating layer;
   a heating step of heating the coating layer after the coating step to form a first layer formed of a plurality of particles containing the perovskite structure as a main component or an aggregate of the particles or a thin film containing the perovskite structure as a main component and a second layer formed of a plurality of particles containing the inorganic transition metal as a main component or an aggregate of the particles or a thin film containing the inorganic transition metal as a main component; and
   a step of applying a solution containing an organic ligand to a surface, which is opposite to a surface in contact with the first layer, of the second layer after the heating step.

### [Advantageous Effects of Invention]

According to the above aspects of the present invention, it is possible to provide a photoelectric conversion element having high efficiency and high sensitivity to a weak optical signal while reducing its environmental load, and having more excellent responsiveness, a photoelectric conversion device, a light detection method, and a method for producing a photoelectric conversion element.

### [Brief Description of Drawings]

FIG. 1 is a cross-sectional view of a photoelectric conversion element according to an embodiment of the present invention.
FIG. 2 is a cross-sectional view of an example of a method for producing the photoelectric conversion element in FIG. 1.
FIG. 3 shows a structure of an energy band of each layer during operation of the photoelectric conversion element in FIG. 1.
FIG. 4 is a graph showing a response speed of a photocurrent obtained in the photoelectric conversion element according to Example 1 of the present invention.
FIG. 5 is a view showing a relationship between a concentration of Eu and a surface potential during light irradiation. The upper part in the drawing is the experimental result in a test plot of "with light irradiation", while the lower part in the drawing is the experimental result in a control test plot of "without light irradiation". A potential level bar (lower limit value: 0.2 V to upper limit value: 0.5 V) represented by shading is shown on the right side of the potential image at each concentration of Eu.

### [Description of Embodiments]

Hereinafter, a photoelectric conversion element, a photoelectric conversion device, a light detection method, and a method for producing a photoelectric conversion element according to an embodiment to which the present invention is applied will be described in detail with reference to the drawings. Note that, in the drawings used in the following description, in order to facilitate understanding of characteristics, characteristic parts may be shown in an enlarged manner for convenience, and dimensional ratios and the like of the respective components are not necessarily the same as actual ones. In addition, materials, dimensions, and the like exemplified in the following description are merely examples, and the present invention is not limited thereto, and can be appropriately changed and implemented without changing the gist thereof.

### (Photoelectric conversion element)

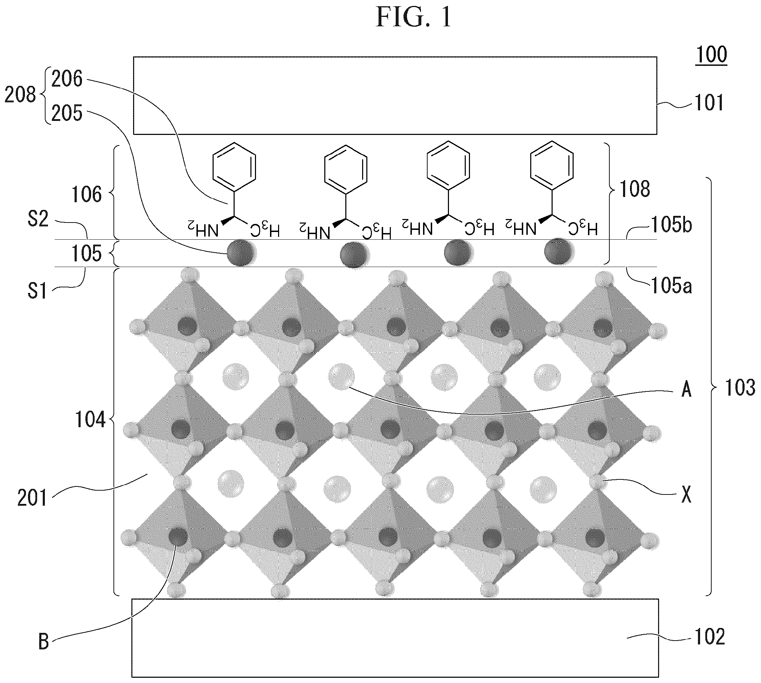

FIG. 1 is a cross-sectional view schematically showing a configuration of a photoelectric conversion element 100 according to an embodiment of the present invention. The photoelectric conversion element 100 includes a positive electrode layer (positive electrode member) 101, a negative electrode layer (negative electrode member) 102, and a photoelectric conversion layer 103 between the positive electrode layer 101 and the negative electrode layer 102. In the photoelectric conversion element 100, the negative electrode layer 102 is laminated on a side opposite to the second layer 105 with the first layer 104 interposed therebetween. In the photoelectric conversion element 100, the positive electrode layer 101 is laminated on a side opposite to the second layer 105 with the third layer 106 interposed therebetween.

When the positive electrode layer (positive electrode member) 101 or the negative electrode layer (negative electrode member) 102 is used on a light-transmitting side, it is preferable to use a light-transmitting material (that is, a transparent or translucent electrode material). Examples of the electrode material of these electrode layers include a conductive metal oxide film and a translucent metal thin film. Specifically, for example, a film produced using a conductive material such as indium oxide, zinc oxide, tin oxide, or tin-doped indium oxide (indium tin oxide) (ITO), indium zinc oxide (IZO), or NESA, which is a composite thereof, or a film produced using gold, platinum, silver, copper, or the like is used. Among these electrode materials, ITO, indium zinc oxide, and tin oxide are preferable. Examples of the method for producing an electrode include a vacuum deposition method, a sputtering method, an ion plating method, and a plating method. As the electrode material, an organic transparent conductive film such as polyaniline and a derivative thereof, or polythiophene and a derivative thereof may be used.

The other electrode that does not need to transmit light need not be transparent. As an electrode material of the other electrode, a metal, a conductive polymer, or the like can be used. Specific examples of the electrode material include metals (first metals) such as aluminum (Al) and zinc (Zn), and alloys of two or more thereof, alloys of one or more of the first metals and one or more metals selected from the group consisting of gold (Au), silver (Ag), platinum (Pt), copper (Cu), manganese (Mn), titanium (Ti), cobalt (Co), nickel (Ni), tungsten (W), and tin (Sn), graphite, graphite intercalation compounds, and conductive polymers such as polyaniline and polythiophene. Examples of the alloy include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy.

In order to take light into the photoelectric conversion layer 103, the negative electrode layer 102 is preferably made of a light-transmitting material such as antimony-doped tin oxide (ATO), tin-doped indium oxide (ITO), zinc oxide, tin oxide, or fluorine-doped tin oxide (FTO). In the production process of the photoelectric conversion element 100 of the present embodiment, it is necessary to perform a heat treatment, and thus, among these materials, ATO having heat resistance is preferable as the material of the negative electrode layer 102.

As shown in FIG. 1, the photoelectric conversion layer 103 according to the present embodiment includes a first layer 104 formed of a plurality of particles containing a perovskite structure 201 as a main component or an aggregate thereof or a thin film containing the perovskite structure 201 as a main component, a second layer 105 formed of a plurality of particles containing an inorganic transition metal 205 different from a central metal contained in the perovskite structure 201 as a main component or an aggregate thereof or a thin film containing the inorganic transition metal 205 different from a central metal contained in the perovskite structure 201 as a main component, and a third layer 106 formed of a plurality of particles containing an organic ligand 206 as a main component or an aggregate thereof or a thin film containing the organic ligand 206 as a main component in this order. In the photoelectric conversion element 100, the positive electrode layer 101, the third layer 106, the second layer 105, the first layer 104, and the negative electrode layer 102 are laminated in this order. Here, the second layer 105 and the third layer 106 form an organometallic complex layer 108. The photoelectric conversion layer 103 is preferably configured such that a conductive path is formed from the positive electrode layer 101 to the negative electrode layer 102. It is preferable that the number of conductive paths formed is as large as possible. Note that the "layer" in the present embodiment means a film formed by a film forming process once or multiple times, is not limited to a flat film, and need not be integrated.

In the photoelectric conversion layer 103, the materials and compositions of the first layer 104 and the organometallic complex layer 108 are preferably determined such that the energy level of the conduction band (Lowest Unoccupied Molecular Orbital (LUMO), excited state) of the organometallic complex layer 108 is higher than that of the first layer 104, while the energy level of the valence band (Highest Occupied Molecular Orbital (HOMO), ground state) of the first layer 104 is higher than that of the organometallic complex layer 108. In the conduction band, the energy level of LUMO of the conduction band of the organometallic complex layer 108 is higher than the energy level of the conduction band of the first layer 104. For example, in the first layer 104, the energy level of the valence band can be set to -5.5 eV or more, and the energy level of the conduction band can be set to -3 eV or less. In the organometallic complex layer 108 (preferably, for example, ions of the inorganic transition metal 205), the energy level of HOMO of the valence band is preferably set to -6 eV or more, and the energy level of LUMO of the conduction band is preferably set to -2 eV or less. As a method for measuring the energy level, for example, ultraviolet photoelectron spectroscopy (UPS) in a vacuum or an air atmosphere may be used. In addition, in some cases, a value of an energy level already published in a document may be substituted.

The photoelectric conversion layer 103 according to the present embodiment may include an inorganic semiconductor layer 107 containing an inorganic semiconductor as a main component, a first layer 104 formed of a plurality of particles containing a perovskite structure 201 as a main component or an aggregate thereof or a thin film containing the perovskite structure 201 as a main component, a second layer 105 formed of a plurality of particles containing an inorganic transition metal 205 different from a central metal contained in the perovskite structure 201 as a main component or an aggregate thereof or a thin film containing the inorganic transition metal 205 different from a central metal contained in the perovskite structure 201 as a main component , and a third layer 106 formed of a plurality of particles containing an organic ligand 206 as a main component or an aggregate thereof or a thin film containing an organic ligand 206 as a main component in this order.

### (When inorganic semiconductor layer 107 is present)

When the inorganic semiconductor layer 107 is present, the inorganic semiconductor layer 107 is provided on the negative electrode layer 102. The form of the inorganic semiconductor layer 107 is not particularly limited. The form of the inorganic semiconductor layer 107 is, for example, a porous film formed of an aggregate of a plurality of particles and having a plurality of voids between the particles. When the inorganic semiconductor layer 107 is formed of particles, it is preferable that the particles in contact with the first layer 104 are in contact with the negative electrode layer 102 directly or indirectly via other particles so as to be electrically connected to the negative electrode layer 102.

The inorganic semiconductor contained in the inorganic semiconductor layer 107 is preferably one having an absorption wavelength in the ultraviolet light region, and examples thereof include titanium oxide and zinc oxide. The thickness of the first layer 104 is preferably about 10 nm or more and 1,000 nm or less, and more preferably about 50 nm or more and 500 nm or less. The inorganic semiconductor layer 107 may be formed only of an inorganic semiconductor.

### (First layer 104)

The first layer 104 is formed of a plurality of particles containing the perovskite structure 201 as a main component or an aggregate thereof or a thin film containing the perovskite structure 201 as a main component. The form of the first layer 104 is preferably a thin film. The content of the perovskite structure 201 in the first layer 104 is 60 mass% or more with respect to the total mass of the first layer 104. The content of the perovskite structure 201 is more preferably 80 mass% or more. Since the first layer 104 may be formed only of the perovskite structure 201, the upper limit of the content of the perovskite structure 201 is 100 mass%.

The perovskite structure 201 forming the first layer 104 is, for example, a compound ABX₃ formed of three types of ions A, B, and X. The perovskite structure 201 is preferably an inorganic perovskite compound in order to segregate the inorganic transition metal 205 different from the central metal contained in the perovskite structure 201. Specifically, the ion B and the ion X form a plurality of units (BX₆)⁴⁻ having an octahedral structure, and the octahedral structures of adjacent units share one surface. The ion B is disposed at the center of the octahedron, and the ion X is disposed at the apices of the octahedron. Here, the central metal is the ion B disposed at the center of the octahedron. The ion A is disposed at a position circumscribing the octahedral structure of each unit. The ion A is, for example, a metal cation such as Cs⁺, K⁺, or Rb⁺, or an organic cation such as CH₃NH₃⁺(MA) or NH=CHNH₂⁺(FA). The ion B is a lead ion (Pb²⁺) or a tin ion (Sn²⁺). X is a halogenated anion such as I⁻, Cl⁻ or Br⁻. The size and shape of the band gap can be changed by an ion selected from each of the ion A, the ion B, and the ion X. When tin is added to the perovskite structure 201, the band gap is narrowed, and the responsiveness to long-wavelength light such as near-infrared light can be improved.

In addition, it is preferable that the energy level of the valence band of the first layer 104 is higher than the energy level of HOMO of the valence band of the organometallic complex layer 108, and is intermittently connected to the same energy order. Examples of the composition of the first layer 104 (perovskite structure) satisfying these conditions include CsPbX₃ (X = Br or I) and CH₃NH₃PbI₃.

The thickness of the first layer 104 is not particularly limited. For example, the thickness of the first layer 104 is 1 to 10 nm.

The second layer 105 is preferably a layer in which the inorganic transition metal 205 is segregated at the surface of the first layer 104 so as to be directly bonded to the perovskite structure of the first layer 104. The second layer 105 is preferably a monatomic layer of the inorganic transition metal 205. The content of the inorganic transition metal 205 in the second layer 105 is 60 mass% or more with respect to the total mass of the second layer 105. The content of the inorganic transition metal 205 is more preferably 80 mass% or more. Since the second layer 105 may be formed only of the inorganic transition metal 205, the upper limit of the content of the inorganic transition metal 205 is 100 mass%. The inorganic transition metal 205 is preferably a metal cation. Examples of the metal cation include Eu³⁺ and Cr³⁺ whose reduction level is LUMO, and Ru²⁺, Fe²⁺, Mn²⁺, and Co²⁺ or the like whose oxidation level is HOMO. Eu³⁺ is particularly preferable. The inorganic transition metal 205 in the second layer 105 is different from the central metal (ion B) contained in the first layer 104. Since the inorganic transition metal 205, which is different from the central metal contained in the perovskite structure 201, in the second layer 105 is different from the metal contained in the first layer 104, the hole collection efficiency can be further enhanced, and the response speed of the photoelectric conversion element 100 can be improved.

The third layer 106 is provided on and in contact with the second layer 105. In order to realize the amplification of the photocurrent, an organometallic complex 208 is preferably bonded to the molecule of the perovskite structure such that the organic ligand 206 and the inorganic transition metal ion 205 different from the central metal contained in the perovskite structure 201 are arranged in this order in the current path from the positive electrode layer 101 side toward the second layer 105 side. That is, the organometallic complex layer 108 is divided into the second layer 105 formed of inorganic transition metal ions and the third layer 106 formed of organic ligand ions. The third layer 106 is preferably a monomolecular layer of the organic ligand 206. The content of the organic ligand 206 in the third layer 106 is 60 mass% or more with respect to the total mass of the third layer 106. The content of the organic ligand 206 is more preferably 80 mass% or more. Since the third layer 106 may be formed only of the organic ligand 206, the upper limit of the content of the organic ligand 206 is 100 mass%. The boundary between the two layers can sometimes be checked using, for example, a transmission electron microscope (TEM) or the like.

Examples of the organic ligand 206 here include a general ligand of a metal complex, for example, (i) an organic compound having a carboxyl group, a nitro group, a sulfo group, a phosphate group, a hydroxy group, an oxo group, an amino group, or the like; (ii) an ethylenediamine derivative; (iii) a heteroatom-containing cyclic organic ligand such as a terpyridine derivative, a phenanthroline derivative, or a bipyridine derivative; (iv) an acetylacetonate-based organic ligand (here, the "acetylacetonate-based organic ligand" means an organic ligand capable of forming a coordinate bond to many transition metal ions (for example, while forming a six-membered ring) via two oxygen atoms) such as a catechol derivative, a quinone derivative, a naphthoic acid derivative, or an acetylacetonate derivative (specifically, for example, acetylacetone). The terpyridine derivative has a structure represented by the following formula (1). As the organic ligand 206, α-methylbenzylamine or terpyridine is preferable. α-Methylbenzylamine has a structure represented by the following formula (2).

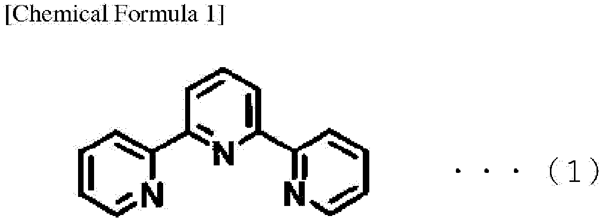

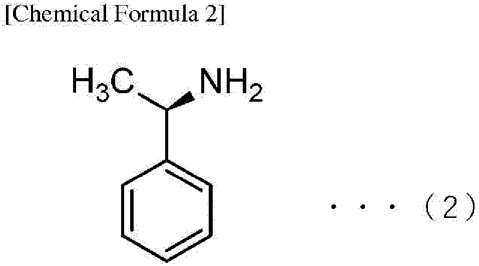

In the photoelectric conversion element 100, at an interface S1 between the first layer 104 and the second layer 105, the perovskite structure 201 and the inorganic transition metal 205, which is different from the central metal contained in the perovskite structure 201, in the second layer 105 form a one-to-one layer arrangement. Here, the phrase "at an interface S1 between the first layer 104 and the second layer 105, the perovskite structure 201 and the inorganic transition metal 205, which is different from the central metal contained in the perovskite structure 201, in the second layer 105 make a one-to-one layer arrangement" means that an atom of the inorganic transition metal 205 different from the central metal contained in one perovskite structure 201 is disposed for one octahedral structure at a position circumscribing the octahedral structure of a unit forming the perovskite structure 201 at the interface S1 between the first layer 104 and the second layer 105. At the interface S1 between the first layer 104 and the second layer 105, the perovskite structure 201 and the inorganic transition metal 205, which is different from the central metal contained in the perovskite structure 201, in the second layer 105 form a one-to-one layer arrangement, so that uniform hole collection can be more efficiently achieved. As a result, the response speed of the photoelectric conversion element 100 can be improved.

At the interface S1 between the first layer 104 and the second layer 105, it can be checked that the perovskite structure 201 and the inorganic transition metal 205, which is different from the central metal contained in the perovskite structure 201, in the second layer 105 make a one-to-one layer arrangement by, for example, observing a cross section of the photoelectric conversion element 100 with a SEM or measuring a surface potential using a scanning probe microscope.

The scanning probe microscope is usually a method for observing the surface shape and surface structure of a sample, but for example, in addition to the observation of the surface shape of a sample (that is, acquisition of height information), other physical property information of the surface of a sample such as a current, a potential, a hardness, or viscoelasticity is measured, and then an analysis such as texture display for displaying the height information overlaid with the other physical property information or a 3D cross-sectional shape analysis function is performed, and thus the presence or absence, state, property, influence, or the like of a coordinate bond can be evaluated from the obtained image.

In this way, it is possible to indirectly check that the perovskite structure 201 and the inorganic transition metal 205 form a one-to-one layer arrangement at a position circumscribing the octahedral structure of the unit forming the perovskite structure 201 by ascertaining the charge state of the surface of an obtained sample and examining the presence or absence of a coordinate bond between the perovskite structure 201 and the inorganic transition metal 205 and the state thereof.

In addition, an atomic force microscope is also a method for observing the surface shape of a sample, but since it is possible to measure the interatomic distance, it is possible to observe a change in the distance between the perovskite structure 201 and the inorganic transition metal 205, and thus, it is possible to indirectly check that the perovskite structure 201 and the inorganic transition metal 205 form a one-to-one layer arrangement at a position circumscribing the octahedral structure of the unit forming the perovskite structure 201. In addition, as in the case of the scanning probe microscope described above, it is also possible to evaluate the presence or absence, state, property, influence, or the like of a coordinate bond from an obtained image by observing an electric force (electric gradient force) or a magnetic image simultaneously with a surface shape image using a cantilever having conductivity or magnetism.

Other methods include an optical method (for example, a method in which an optical change caused by an intramolecular electron transition in a coordinate bond for forming a one-to-one layer arrangement is detected using spectroscopy by light absorption or scattering) and a magnetic method (for example, a method in which a magnetic change caused by a change in a spin state of a transition metal ion is detected using an electron magnetic resonance method).

In the photoelectric conversion element 100, at an interface S2 between the second layer 105 and the third layer 106, the inorganic transition metal 205, which is different from the central metal contained in the perovskite structure 201, in the second layer 105 and the organic ligand 206 in the third layer 106 are combined to form the organometallic complex layer 108 made of the organometallic complex 208. The formation of the organometallic complex layer 108 made of the organometallic complex 208 by combining the inorganic transition metal 205 and the organic ligand 206 in the third layer 106 enables efficient amplification of the photocurrent of the photoelectric conversion element 100 even for a weak optical signal.

In the photoelectric conversion element 100, it can be checked that the inorganic transition metal 205, which is different from the central metal contained in the perovskite structure 201, in the second layer 105 and the organic ligand 206 in the third layer 106 are combined to form the organometallic complex layer 108 made of the organometallic complex 208 at the interface S2 between the second layer 105 and the third layer 106 by, for example, X-ray photoelectron spectroscopy (XPS) or infrared spectroscopy (FT-IR).

In a case where the photoelectric conversion element 100 of the present embodiment is applied to an optical sensor, the photoelectric conversion element 100 is mounted on a semiconductor substrate such as silicon or a glass substrate. In this case, for example, the following device configurations can be exemplified:
(1) a mode in which the negative electrode layer 102 having transparency is formed on an uppermost layer farthest from the semiconductor substrate (that is, a configuration in which the (transparent) negative electrode layer 102/the first layer 104/the organometallic complex layer 108/the positive electrode layer 101/the (Si) substrate are laminated in this order from the uppermost layer on the light incident side);
(2) a mode in which the positive electrode layer 101 having transparency is formed on an uppermost layer farthest from the semiconductor substrate (that is, a configuration in which the (transparent) positive electrode layer 101/the organometallic complex layer 108/the first layer 104/the negative electrode layer 102/the (Si) substrate are laminated in this order from the uppermost layer on the light incident side); and
(3) a mode in which the negative electrode layer 102 having transparency is formed so as to be adjacent to the glass substrate (that is, a configuration in which the (glass) substrate/the negative electrode layer 102/the first layer 104/the organometallic complex layer 108/the positive electrode layer 101 are laminated in this order from the uppermost layer on the light incident side).

Examples of another device configuration include a configuration in which in the device configurations of the above (1) to (3), an inorganic semiconductor 107 is present between the (transparent) negative electrode layer 102 and the first layer 104.

In the photoelectric conversion element 100, it is preferable that the central metal contained in the perovskite structure 201 is lead, the inorganic transition metal 205 in the second layer 105 is europium, the inorganic transition metal in the second layer 105 forming the organometallic complex 208 is europium, and the organic ligand 206 forming the organometallic complex 208 is α-methylbenzylamine or terpyridine.

### (Method for producing photoelectric conversion element 100)

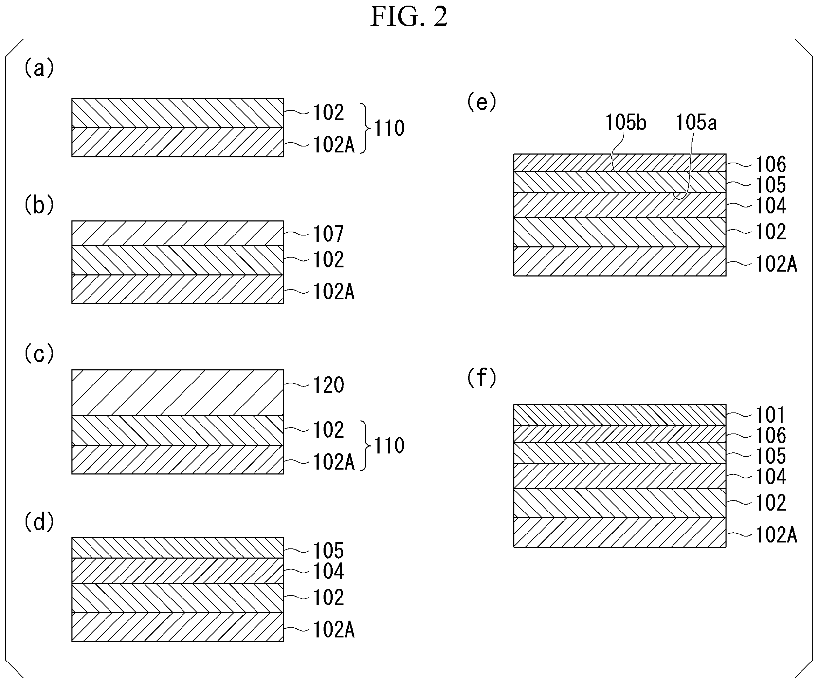

FIGS. 2(a) to 2(f) are cross-sectional views showing an example of a production process of the photoelectric conversion element 100. The photoelectric conversion element 100 can be produced mainly through the following procedure. For reference, FIG. 2(d) shows an example of a production process as an additional procedure in a case where the inorganic semiconductor 107 is present between the (transparent) negative electrode layer 102 and the first layer 104.

First, as shown in FIG. 2 (a), a substrate 110 including the negative electrode layer 102 for forming the photoelectric conversion layer 103 is prepared. The substrate 110 includes a support substrate 102A and the negative electrode layer 102 provided on the support substrate 102A. When light is taken in from the substrate 110 side, the support substrate 102A and the negative electrode layer 102 have light transmittance. The support substrate 10A is, for example, glass. The negative electrode layer 102 functions as a negative electrode layer, and uses an electrode member having transparent conductivity.

A buffer layer (not shown) may be formed on one surface of the negative electrode layer 102. The buffer layer can be formed by applying a solution of a material to the negative electrode layer 102 using a spin coating method or the like and heating (drying) the solution. This heating may be performed, for example, at about 120 to 450°C for about 10 to 60 minutes. The material application conditions (application time, and the like) may be adjusted so that the thickness of the buffer layer is, for example, about 1 to 100 nm.

When the inorganic semiconductor 107 is present between the (transparent) negative electrode layer 102 and the first layer 104 as in the "another device configuration" described above, it is only necessary to produce an intermediate member having a desired configuration by adding the following procedure as shown in FIG. 2(b) instead of the intermediate member shown in FIG. 2(a).

First, the inorganic semiconductor layer 107 containing an inorganic semiconductor as a main component is formed on one surface side of the negative electrode layer 102 (with a buffer layer interposed therebetween when there is a buffer layer). A method for forming the inorganic semiconductor layer 107 is not particularly limited. For example, the inorganic semiconductor layer 107 may be formed by vacuum deposition, or may be formed by applying a dispersion liquid of particles containing an inorganic semiconductor to the negative electrode layer 102 and heating the dispersion liquid. The dispersion liquid application conditions (application time and the like) may be adjusted so that the thickness of the first layer 104 is, for example, about 10 to 1,000 nm, preferably about 50 to 500 nm.

In the subsequent production process, the photoelectric conversion element 100 can be produced through a similar procedure (that is, FIGS. 2(c) to 2(f)) using the intermediate member shown in FIG. 2(b) instead of the intermediate member shown in FIG. 2(a).

Subsequently, as shown in FIG. 2(c), the surface of the substrate 110 is coated with a mixture containing a raw material of the perovskite structure 201 and an inorganic transition metal different from the central metal contained in the perovskite structure 201 (first step). Specifically, the negative electrode layer 102 (when the inorganic semiconductor layer 107 is present, the inorganic semiconductor layer 107) is coated with a mixture containing a raw material of the perovskite structure and the inorganic transition metal 205 different from the central metal contained in the perovskite structure 201. Thus, the coating layer 120 is formed. Hereinafter, a method for forming the coating layer 120 will be described.

First, a raw material of the perovskite structure and the inorganic transition metal (hereinafter sometimes referred to as a second layer inorganic transition metal) 205 that is contained in the raw material of the perovskite structure and is different from the central metal contained in the perovskite structure 201 are mixed to obtain a mixture (mixing step). Examples of the raw material of the perovskite structure include a compound containing the ion A and the ion X (hereinafter sometimes referred to as a first compound) and a compound containing the ion B and the ion X (hereinafter sometimes referred to as a second compound). Examples of the compound containing the ion A and the ion X include CsCl, CsBr, CsI, MACl, MABr, MAI, FACl, FABr, and FAI. MA of MACl represents CH₃NH₃⁺, and FA represents NH=CHNH₂⁺. Examples of the compound containing the ion B and the ion X include PbCl₂, PbBr₂, PbI₂, SnCl₂, SnBr₂, and SnI₂.

The second layer inorganic transition metal in the mixture may be contained as a metal simple substance or may be contained as a compound containing the second layer inorganic transition metal. The mixture preferably contains a compound containing the second layer inorganic transition metal. The compound containing the second layer inorganic transition metal is, for example, a compound containing the second layer inorganic transition compound and the ion X (hereinafter sometimes referred to as a third compound). Examples of the compound containing the second layer inorganic transition compound and the ion X include EuClz, EuBr₂, EuI₂, YbCl₂, YbBr₂, and YbI₂.

As for the ratio of the first compound, the second compound, and the third compound as the whole mixture, for example, it is preferable to determine the ratio of each component so that the molar ratio of the ion A, the ion B, the ion X, and the second layer inorganic transition metal (ion A : ion B : ion X : second layer inorganic transition metal) satisfies 1 : 1 : 3 : 0.3 to 1. For example, in order to make the second layer 105 a monatomic layer, the molar ratio of the ion A, the ion B, the ion X, and the second layer inorganic transition metal as the whole mixture is preferably 1 : 1 : 3 : 0.3 so that the final film composition ratio is 1 : 1 : 3 : 0.01. In this case, as a specific operation for making the second layer 105 a monatomic layer, for example, as in Example 1 described later, a coating layer having a two-layer structure may be formed by forming a film with a solution (a molar ratio of the ion B : the ion X : the second layer inorganic transition metal as the whole mixture: 1 : 3 : 0.3) obtained by mixing the ion B, the ion X, and the second layer inorganic transition metal, and then applying a solution containing the ion A (a molar ratio of the ion A is 1 as the whole mixture). The total content of the first compound, the second compound, and the third compound as the whole mixture is 90 mass% or more with respect to the total mass of the mixture. Since the mixture as a whole may be formed only of the first compound, the second compound, and the third compound, the upper limit of the total content of the first compound, the second compound, and the third compound as the whole mixture is 100 mass%.

The mixture may be a solution containing the raw material of the perovskite structure and the second layer inorganic transition metal, or may be a combination of a solution containing a part of the raw material of the perovskite structure and the second layer inorganic transition metal and a solution containing another part of the raw material of the perovskite structure. When the mixture is a solution containing the raw material of the perovskite structure and the second layer inorganic transition metal or a combination of a solution containing a part of the raw material of the perovskite structure and the second layer inorganic transition metal and a solution containing another part of the raw material of the perovskite structure, the coating layer 120 having a uniform thickness can be formed using spin coating or the like. When the mixture is a solution, a solvent is not particularly limited as long as it is a solvent capable of dissolving the first compound, the second compound, and the third compound. Examples of the solvent include dimethylsulfoxide (DMSO), dimethylformamide (DMF), and γ-butyrolactone. When the mixture is a solution, the total content of the first compound, the second compound, and the third compound is 90 mass% or more with respect to the total mass of the mixture after drying. Since the whole mixture after drying may be formed only of the first compound, the second compound, and the third compound, the upper limit of the total content of the first compound, the second compound, and the third compound as the whole mixture after drying is 100 mass%.

Subsequently, the surface of the base material 110 is coated with the mixture to form the coating layer 120 (coating step). The method for forming the coating layer 120 is not particularly limited. Examples of the method for forming the coating layer 120 include a spin coating method and a dipping method. The coating layer 120 is preferably formed by applying a solution containing the raw material of the perovskite structure and the second layer inorganic transition metal or a combination of a solution containing a part of the raw material of the perovskite structure and the second layer inorganic transition metal and a solution containing another part of the raw material of the perovskite structure, and heating and drying the solution. The heating may be performed, for example, at about 40 to 100°C for about 5 to 10 minutes. The material application conditions (application time and the like) are adjusted so that the thickness of the coating layer 120 is, for example, about 1 to 10 nm. The coating layer 120 may be a single layer containing all of the first compound, the second compound, and the third compound as the whole mixture. The coating layer 120 may be formed of two or more layers. Examples of a case where the coating layer 120 is formed of two or more layers include a case where the coating layer is formed of a layer containing the second compound and the third compound and a layer containing the first compound provided on the layer containing the second compound and the third compound.

Subsequently, as shown in FIG. 2(d), after the first step, by forming a one-to-one layer arrangement between the perovskite structure 201 and the second layer inorganic transition metal 205, the first layer formed of a plurality of particles containing the perovskite structure 201 as a main component or an aggregate thereof or a thin film containing the perovskite structure 201 as a main component and the second layer formed of a plurality of particles containing the second layer inorganic transition metal 205 as a main component or an aggregate thereof or a thin film containing the second layer inorganic transition metal 205 as a main component or an aggregate are formed (second step). A method for forming the one-to-one layer arrangement between the perovskite structure 201 and the second layer inorganic transition metal 205 is not particularly limited. For example, the coating layer 120 may be heated to form the first layer 104 formed of a plurality of particles containing the perovskite structure 201 as a main component or an aggregate thereof or a thin film containing the perovskite structure 201 as a main component and the second layer 105 formed of a plurality of particles containing the second layer inorganic transition metal 205 as a main component or an aggregate thereof or a thin film containing the second layer inorganic transition metal 205 as a main component (heating step). The form of the first layer 104 is preferably a thin film. The form of the second layer 105 is preferably a thin film. The perovskite structure 201 is formed from the first compound and the second compound by heating. By forming the perovskite structure 201, the first layer 104 is formed. At this time, the second layer 105 is formed by segregating the second layer inorganic transition metal 205 at the surface of the first layer 104 together with the formation of the first layer 104, and a one-to-one layer arrangement is formed between the perovskite structure 201 and the second layer inorganic transition metal 205. The second layer 105 is preferably a monatomic layer.

The heating temperature is not particularly limited as long as the perovskite structure 201 is formed and the second layer inorganic transition metal 205 can be segregated at the surface of the first layer 104. The heating temperature is, for example, 200°C to 300°C. The heating time is not particularly limited as long as the perovskite structure 201 is formed and the second layer inorganic transition metal 205 can be segregated at the surface of the first layer 104. The heating time is preferably, for example, 5 minutes or more. More preferably, the heating time is, for example, 5 minutes or more and 60 minutes or less. Still more preferably, the heating time can be, for example, 20 minutes or more and 30 minutes or less.

Subsequently, as shown in FIG. 2(e), the third layer 106 formed of a plurality of particles containing the organic ligand 206 as a main component or an aggregate thereof or a thin film containing the organic ligand 206 as a main component is formed on the second layer 105. The form of the third layer 106 is preferably a monomolecular thin film. At this time, the organic ligand 206 is bonded to the second layer inorganic transition metal 205 through a coordinate bond at a second surface 105b, which is opposite to a surface 105a in contact with the first layer 104, of the second layer 105 to form the organometallic complex layer 108 made of an organometallic complex (third step). The method for bonding the organic ligand 206 to the second layer inorganic transition metal 205 through a coordinate bond is not particularly limited. For example, a solution containing the organic ligand 206 is applied onto the second layer 105 (application step) and held for a certain period of time (for example, 30 seconds). The organometallic complex layer 108 may be formed by drying after holding. It is preferable to remove the organic ligand 206 that does not form the organometallic complex 208. A method for removing the organic ligand 206 is not particularly limited. For example, the organic ligand 206 that does not form the organometallic complex 208 can be removed by washing the substrate 110 with an organic solvent or the like.

Finally, as shown in FIG. 2(f), the photoelectric conversion element 100 of the present embodiment can be obtained by forming the positive electrode layer 101 on the third layer 106, more specifically, on a layer made of the organic ligand. A method for forming the positive electrode layer 101 is not particularly limited. The positive electrode layer 101 may be formed, for example, by vacuum deposition or by applying a conductive paste.

### (Energy band structure)

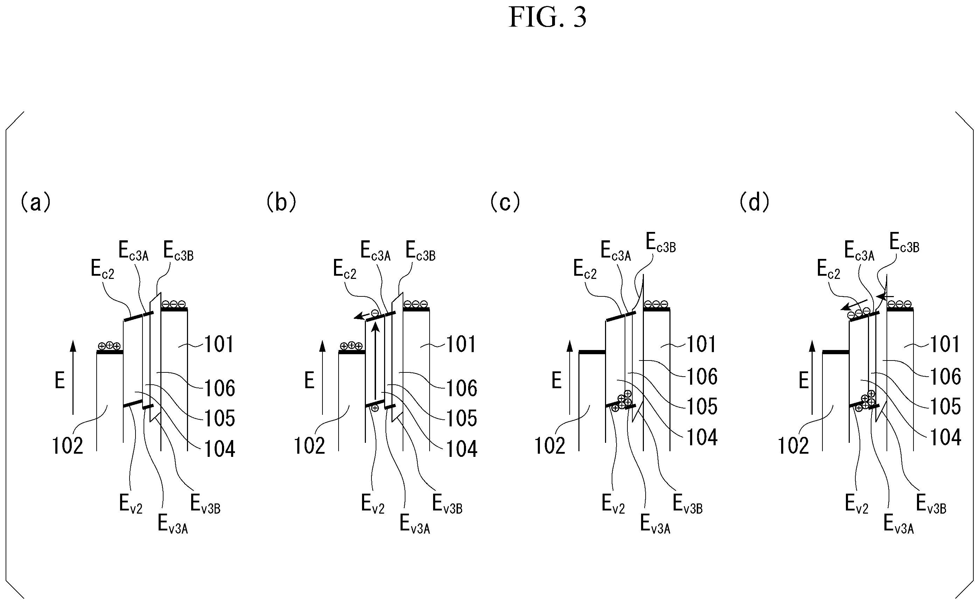

FIGS. 3(a) to 3(d) are diagrams for explaining the operation principle (operation) of the photoelectric conversion element 100 according to the present embodiment. The respective drawings show the structures of the energy bands of the respective layers before light irradiation, immediately after light irradiation, and after elapse of a predetermined time after light irradiation.

In a state of no light irradiation, the energy level of the conduction band of the organometallic complex layer 108 is higher than the Fermi level of the positive electrode layer 101 on the positive electrode layer 101 side, and as shown in FIG. 3(a), a current from the positive electrode layer 101 toward the negative electrode layer 102 is blocked.

When the photoelectric conversion element 100 is irradiated with light, the perovskite structure forming the first layer 104 absorbs the light to generate electrons and holes, and as shown in FIG. 3(b), the electrons transfer to the conduction band and the holes transfer to the valence band.

At this time, since the energy level E_{c2} of the conduction band of the first layer 104 and the energy level E_{c3} of LUMO of the conduction band of the organometallic complex layer 108 have a relationship of E_{c3} > E_{c2}, electrons generated in the first layer 104 and transferred to the conduction band of the same layer transfer to the conduction band of the organometallic complex layer 108 in a lower energy state as shown in FIG. 3(c). In FIG. 3, E_{c3A} represents the energy level of LUMO of the conduction band of the second layer 105, and E_{c3B} represents the energy level of LUMO of the conduction band of the third layer 106. Here, the energy level E_{c3} of the organometallic complex layer 108 is defined as E_{c3A} and E_{c3B}.

When the inorganic semiconductor 107 is present between the (transparent) negative electrode layer 102 and the first layer 104, since the energy level E_{c1} of the conduction band of the inorganic semiconductor layer 107, the energy level E_{c2} of the conduction band of the first layer 104, and the energy level E_{c3} of LUMO of the conduction band of the organometallic complex layer 108 have a relationship of E_{c3} > E_{c2} > E_{c1}, electrons generated in the first layer 104 and transferred to the conduction band of the same layer transfer to the conduction band of the organometallic complex layer 108 in a lower energy state, and further transfer to the conduction band of the inorganic semiconductor layer 107 in an even lower energy state. In FIG. 3, E_{c3A} represents the energy level of LUMO of the conduction band of the second layer 105, and E_{c3B} represents the energy level of LUMO of the conduction band of the third layer 106. Here, the energy level E_{c3} of LUMO of the organometallic complex layer 108 is defined as E_{c3A} and E_{c3B}.

On the other hand, since the energy level Eᵥ₂ of the valence band of the first layer 104 and the energy level Eᵥ₃ of HOMO of the valence band of the organometallic complex layer 108 satisfy Eᵥ₂ > Eᵥ₃, holes generated in the first layer 104 and transferred to the valence band are trapped in the valence band of the first layer 104 in a relatively high (low for holes) energy state as compared with the organometallic complex layer 108 as shown in FIG. 3(c).

When the inorganic semiconductor 107 is present between the (transparent) negative electrode layer 102 and the first layer 104, since the energy level Eᵥ₁ of the valence band of the inorganic semiconductor layer 107, the energy level Eᵥ₂ of the valence band of the first layer 104, and the energy level Eᵥ₃ of HOMO of the valence band of the organometallic complex layer 108 satisfy Eᵥ₂ > Eᵥ₁ and Eᵥ₂ > Eᵥ₃, holes generated in the first layer 104 and transferred to the valence band are trapped in the valence band of the first layer 104 in a relatively high (low for holes) energy state as compared with the inorganic semiconductor layer 107 and the organometallic complex layer 108.

Due to the effect of trapped and concentratedly distributed holes (positive potential), the potential energy of electrons decreases and the energy level of the conduction band decreases in the vicinity of the valence band of the first layer 104. Since the energy level of the conduction band largely decreases as it is closer to the first layer 104 in which holes are trapped, the energy level of LUMO of the conduction band of the organometallic complex layer 108 becomes lower on the first layer 104 side, and has a sharp shape on the positive electrode layer side. Therefore, for electrons present in the positive electrode layer 101, the energy barrier of the organometallic complex layer 108 becomes thin, and it becomes possible to tunnel to the negative electrode layer side. That is, when the photoelectric conversion element 100 is irradiated with light, a large number of electrons on the positive electrode side (electrons in a state of no light irradiation) blocked by the energy barrier of the organometallic complex layer 108 are tunneled (transmitted) through the thinned energy barrier and allowed to flow into the negative electrode side, so that it is considered that it is possible to realize significant amplification of a current directly generated by light irradiation.

The total thickness of the second layer 105 and the third layer 106 is preferably, for example, equal to or more than the thickness of the monomolecular layer of the organometallic complex 208. The second layer 105 and the third layer 106 preferably form the monomolecular layer of the organometallic complex 208. The total thickness of the second layer 105 and the third layer 106 is preferably 10 nm or less. If the total thickness of the second layer 105 and the third layer 106 is larger than 10 nm, the energy barrier becomes too thick to obtain a sufficient tunnel probability, and amplification of the photocurrent in the photoelectric conversion element 100 is hindered. In addition, if the second layer 105 and the third layer 106 are thinner than the monomolecular layer of the organometallic complex 208, the tunnel current flows even when the band is not bent without light irradiation and the photodetection function of the photoelectric conversion element 100 becomes meaningless.

### (Light detection method)

The light detection method using the photoelectric conversion element 100 includes steps of allowing the photoelectric conversion layer 103 to receive visible light and/or near-infrared light to cause a current to flow between the negative electrode layer 102 and the positive electrode layer 101; and measuring the current to detect the visible light and/or near-infrared light.

The current generated by receiving light can be measured by a known method. Since the photoelectric conversion element 100 can amplify the absorbed light by a factor of 10⁵, even weak light can be easily detected.

As described above, when the photoelectric conversion element 100 according to the present embodiment is irradiated with light in a driven state by application of a voltage between the positive electrode layer 101 and the negative electrode layer 102, a photocurrent can be generated, amplified, and output. In addition, since the photoelectric conversion element 100 can be driven at a low voltage, output can be performed in a state in which generation of noise is prevented, and the measurement accuracy of a photocurrent can be improved. Therefore, since a photoelectric conversion device such as an optical sensor or a camera including the photoelectric conversion element 100 enables high magnification amplification even at a driving voltage of, for example, 1 V or less, a high bias (that is, a high-voltage drive circuit) becomes unnecessary, and compactness of a product can be achieved. Furthermore, in the photoelectric conversion element 100, since the perovskite structure 201 and the second layer inorganic transition metal 205 form a one-to-one layer arrangement, the response speed can be improved. Furthermore, since the photoelectric conversion element 100 of the present embodiment can easily change the shape of the energy level by adjusting the combination and composition of the materials of the respective layers, the response sensitivity can be increased, and light having a desired wavelength can also be selectively absorbed.

The photoelectric conversion element 100 may include a buffer layer (not shown) between the negative electrode layer 102 and the photoelectric conversion layer 103. The energy level Ecb of the conduction band of the buffer layer is present between the energy level of the negative electrode layer 102 and the energy level of the conduction band of the first layer 104 (when the inorganic semiconductor layer 107 is present, the inorganic semiconductor layer 107). Examples of the material forming the buffer layer include europium oxide (Eu₂O₃), titanium oxide, and tin oxide.

### [Examples]

Hereinafter, the effects of the present invention will be made more apparent from examples. The present invention is not limited to the following examples, and can be appropriately modified without changing the gist thereof.

### (Example 1)

A photoelectric conversion element of Example 1 was produced under the following conditions.

First, as a member to be a negative electrode layer including a base material, a member containing antimony-doped tin oxide (ATO) as a component was prepared. One surface of this member was spin-coated with 200 µl of an ethanol solution of 0.18 M titanium diisopropylate diacetylacetonate at a rotation speed of 3,000 rpm. Subsequently, the mixed liquid applied by spin coating onto the member was heated at 500°C for 30 minutes to form a buffer layer substantially made of a titanium oxide (TiO₂) dense film.

Subsequently, 150 µl of a dimethyl sulfoxide (DMSO) solution of lead iodide (PbI₂) at a concentration of 1.25 M and europium chloride (EuCl₂) at a concentration of 0.375 M was added dropwise onto the surface of the buffer layer (the surface on a side opposite to the negative electrode layer), and spin coating was performed at a rotation speed of 2,000 rpm. Subsequently, the spin-coated member was heated at 150°C for 30 minutes (step A). Onto the spin-coated surface of the member, 100 µl of an anhydrous methanol solution of 0.07 M cesium chloride (CsCl₂) was added dropwise, and spin coating was performed at a rotation speed of 3,000 rpm. By sequentially performing the steps, a coating layer having a two-layer structure was formed on the member (step B). Subsequently, the member including the coating layer was heated at 250°C for 5 minutes. This operation (step A and step B) was repeated five times to form a first layer of the perovskite structure and a second layer of the inorganic transition metal, which is segregated on the first layer and is different from the central metal contained in the perovskite structure.

Subsequently, 200 µl of an isopropyl alcohol (IPA) liquid containing 1-phenylethylamine at a concentration of 20 mM was added dropwise onto the surface of the second layer, and held for 30 seconds. Thereafter, spin coating was performed at a rotation speed of 3,000 rpm. Subsequently, the base material was heated at 100°C for 15 minutes to form a third layer containing 1-phenylethylamine as a main component.

Finally, a positive electrode layer (Ag) was formed on a side opposite to the negative electrode layer with a laminate formed of the first layer, the second layer, and the third layer interposed therebetween so as to be in contact with the third layer, thereby obtaining a photoelectric conversion element of Example 1. In the photoelectric conversion element thus obtained, when the energy level was calculated based on the combination of the used raw materials, in the conduction band, the energy level of LUMO of the conduction band of the organometallic complex layer of Example 1 was higher than the energy level of the conduction band of the first layer, and in the valence band, the energy level of the valence band of the first layer of Example 1 was higher than the energy level of HOMO of the valence band of the organometallic complex layer.

### (Comparative Example 1)

A photoelectric conversion element of Comparative Example 1 was produced under the following conditions.

First, as a member to be a negative electrode layer including a base material, a member containing antimony-doped tin oxide (ATO) as a component was prepared. The surface of this member was spin-coated with 200 µl of an ethanol (C₂H₅OH) liquid containing europium chloride hydrate (EuCl₃·6H₂O) at a concentration of 10 mM at a rotation speed of 3,000 rpm. The base material after spin coating was heated at 120°C for 10 minutes and then heated at 450°C for 1 hour to form a buffer layer of europium oxide (Eu₂O₃).

Subsequently, 120 µl of a mixed liquid containing a titanium oxide (TiO₂) paste (PST18NR, manufactured by JGC Catalysts and Chemicals Ltd.) and ethanol in a weight ratio of 1 : 3.5 was added dropwise onto the surface of the buffer layer, and spin coating was performed at a rotation speed of 6,000 rpm. Subsequently, the spin-coated base material was heated at 120°C for 10 minutes and heated at 450°C for 1 hour to form an inorganic semiconductor layer formed of a plurality of titanium oxide particles.

Subsequently, 100 µl of a mixed solution of dimethylformamide (DMF) and dimethylsulfoxide (DMSO) containing lead iodide (PbI₂) and methylammonium at a concentration of 0.5 M or less was added dropwise onto the base material, and spin coating was performed at a rotation speed of 5,000 rpm. Subsequently, the spin-coated base material was sequentially heated at 40°C for 5 minutes, heated at 70°C for 5 minutes, and heated at 100°C for 10 minutes to form a first layer containing a perovskite structure (CH₃NH₃PbI₃) as a main component on the inorganic semiconductor layer.

After formation of the first layer, 100 µl of an isopropyl alcohol (IPA) liquid containing europium chloride (EuCl₃) at a concentration of 5 mM was added dropwise onto the base material, and spin coating was performed at a rotation speed of 5,000 rpm. Subsequently, the spin-coated base material was heated at 100°C for 15 minutes to form a second layer containing europium as a main component on the first layer.

After formation of the second layer, 200 µl of an isopropyl alcohol (IPA) liquid containing terpyridine (2,2':6',2"-terpyridine) at a concentration of 20 mM was added dropwise onto the surface of the layer containing europium as a main component, and held for 30 seconds. Thereafter, spin coating was performed at a rotation speed of 3,000 rpm. Subsequently, the base material was heated at 100°C for 15 minutes to form a third layer containing terpyridine as a main component.

Finally, a positive electrode layer (Ag) was formed on a side opposite to the negative electrode layer with a laminate formed of the inorganic semiconductor layer, the first layer, the second layer, and the third layer interposed therebetween so as to be in contact with the third layer, thereby obtaining a photoelectric conversion element of Comparative Example 1.

### (Example 2)

A photoelectric conversion element of Example 2 was produced by the following method. As a member to be a negative electrode layer including a base material, a member containing antimony-doped tin oxide (ATO) as a component was prepared. One surface of this member was spin-coated with 120 µl of a mixed liquid containing a titanium oxide (TiO2) paste (PST18NR, manufactured by JGC Catalysts and Chemicals Ltd.) and ethanol in a weight ratio of 1 : 3.5 at a rotation speed of 6,000 rpm. Subsequently, the mixed liquid applied by spin coating onto the substrate was sequentially heated at 120°C for 10 minutes and at 450°C for 1 hour to form a porous film formed of a plurality of particles substantially made of titanium oxide.

Subsequently, 100 µl of a mixed solution of dimethylformamide (DMF) and dimethylsulfoxide (DMSO) containing lead iodide (PbI₂) at a concentration of 0.5 M and methylammonium at a concentration of 0.5 M was added dropwise onto the surface of the porous membrane (the surface on a side opposite to the negative electrode layer), and spin coating was performed at a rotation speed of 5,000 rpm. Subsequently, the spin-coated member was sequentially heated at 40°C for 5 minutes, heated at 70°C for 5 minutes, and heated at 100°C for 10 minutes to form a first layer containing a perovskite structure (CH₃NH₃PbI₃) as a main component on the member.

Subsequently, 100 µl of an isopropyl alcohol (IPA) liquid containing europium chloride (EuCl₃) at a concentration of 1 mM was added dropwise onto the surface of the first layer (a spin-coated surface on a side opposite to the negative electrode layer), and spin coating was performed at a rotation speed of 5,000 rpm. Subsequently, the spin-coated member was heated at 100°C for 15 minutes to form a second layer containing europium as a main component on the first layer, thereby producing a photoelectric conversion element of Example 2.

### (Example 3)

A photoelectric conversion element of Example 3 was produced under the same conditions as in Example 2 except that an isopropyl alcohol (IPA) liquid containing europium chloride (EuCl₃) at a concentration of 5 mM was used.

### (Example 4)

A photoelectric conversion element of Example 4 was produced under the same conditions as in Example 2 except that an isopropyl alcohol (IPA) liquid containing europium chloride (EuCl₃) at a concentration of 7.5 mM was used.

### (Example 5)

A photoelectric conversion element of Example 5 was produced under the same conditions as in Example 2 except that an isopropyl alcohol (IPA) liquid containing europium chloride (EuCl₃) at a concentration of 10 mM was used.

### (Checking of layer arrangement of perovskite structure and inorganic transition metal)

In order to check that the perovskite structure and the inorganic transition metal different from the central metal contained in the perovskite structure form a one-to-one layer arrangement, the following procedure is performed. By observing the cross section of the photoelectric conversion element 100 with a SEM or measuring the surface potential using a scanning probe microscope, it can be checked that the perovskite structure and the inorganic transition metal different from the central metal contained in the perovskite structure exist as a layer having a one-to-one layer arrangement with a thickness of several nanometers. It can also be checked by measuring the presence and bonding state of inorganic transition metal ions present at a surface with a depth of several nanometers using X-ray photoelectron spectroscopy (XPS).

### (Checking of formation of organometallic complex layer)

In order to check that an organometallic complex is formed, the following procedure is performed. By observing the cross section of the photoelectric conversion element 100 with TEM, it can be checked that an organometallic complex in which an organic ligand is bonded to an inorganic transition metal through a coordinate bond forms a layer. In addition, it can be checked that an organometallic complex forms a layer using X-ray photoelectron spectroscopy (XPS) or FT-IR.

### (Response speed)

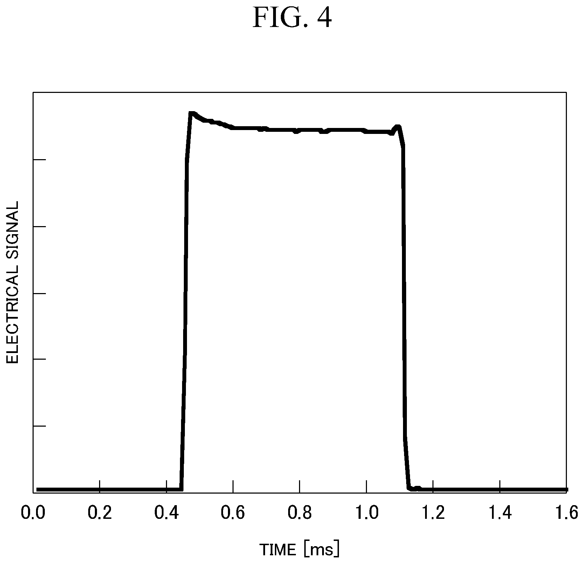

The light irradiation conditions were set for the photoelectric conversion element of Example 1 at a predetermined timing, and a photocurrent generated in the photoelectric conversion element was measured. The voltage applied between the positive electrode layer and the negative electrode layer was set to -0.5 V. The wavelength, irradiance, and irradiation interval (frequency) of light with which the photoelectric conversion element was irradiated were set to 550 nm, 1 mW/cm², and 1,500 Hz, respectively. FIG. 4 is a graph showing measurement results corresponding to the photoelectric conversion element of Example 1. In this graph, the horizontal axis represents an elapsed time (s), and the vertical axis represents a photocurrent (A/cm²).

From the graph in FIG. 4, the photocurrent in the photoelectric conversion element of Example 1 instantaneously increased to a substantially maximum value (maximum value: about 1 A/cm²). The response speed of the photoelectric conversion element of Example 1 was 14 µs. On the other hand, the response speed was 30 to 70 µs in the case of Comparative Example 1. The gain of the photoelectric conversion element of Example 1 was as high as 1,600.

### (Evaluation and measurement of potential)

Subsequently, the relationship between the amount of the second layer inorganic transition metal 205 on the surface of the first layer 104 and the hole collection efficiency was examined. Specifically, the surface potential of each of the photoelectric conversion elements of Examples 2 to 4 produced by changing the concentration of Eu was measured using a scanning probe microscope (SPM-9700HT, manufactured by Shimadzu Corporation). As the cantilever, one coated with Pt was used. The surface potential measurement was performed with light irradiation (irradiation condition: 1 mW/cm²) (that is, a test plot showing the characteristics and effects of the present invention) and without light irradiation (that is, a control test plot showing the characteristics and effects of the present invention).

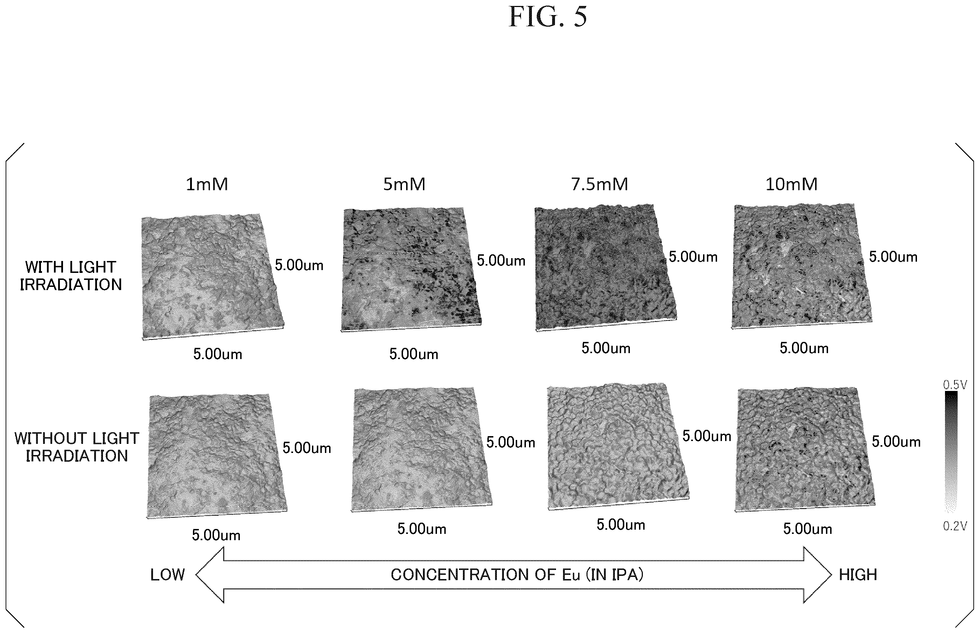

FIG. 5 shows the surface potential measurement results. A potential level bar (lower limit value: 0.2 V to upper limit value: 0.5 V) is shown on the right side of the potential images. In the potential level bar, at a value higher than the center value (0.35 V), a portion with dark shading indicates that the potential is high. On the other hand, at a value lower than the center value (0.35 V) of the potential level bar, a portion with light shading indicates that the potential is low. Then, by collating the degree of shading in the potential level bar with the degree of shading in the potential image, the detailed distribution and state of the potential level in the potential image can be understood.

In the case of no light irradiation, no large change was observed in any potential image, and the potential in this case simplifiedly indicated a value lower than the center value of the potential level bar as the entire potential image, however, in the case of light irradiation, a dark portion increased in the entire potential image up to 7.5 mM, and the potential in this case indicated a value higher than the center value of the potential level bar uniformly in the entire potential image. This indicates that holes can be efficiently collected by coating the surface with Eu. However, when the concentration was more than 10 mM, the dark portion decreased in the entire potential image, and the average potential level was lower than the average potential level in the case of 7.5 mM. This indicates that the hole collection efficiency decreases as the thickness of the second layer increases. It is presumed that up to 7.5 mM, the surface of the first layer 104 is coated at a monatomic layer level. From the above results, it is presumed that the photoelectric conversion element of Example 1 can efficiently collect holes, thereby improving the response speed.

In the evaluation and measurement of the potential, a surface potential measurement result of each sample observed using a scanning probe microscope (SPM-9700HT manufactured by Shimadzu Corporation) is shown in FIG. 5. The surface potential measurement result is a texture display obtained by displaying a surface potential image overlaid with a surface shape image (that is, a height image) observed using a scanning probe microscope (SPM-9700HT manufactured by Shimadzu Corporation) under each condition of "with light irradiation" or "without light irradiation" with the "member obtained by forming the first layer of the perovskite structure and the second layer of the inorganic transition metal, which is segregated on the first layer and is different from the central metal contained in the perovskite structure" (see paragraph [0085]) as a measurement target.

When the Eu concentration is 7.5 mM, a value higher than the center value (0.35 V) of the potential level bar is uniformly indicated in the entire potential image, and therefore, at the Eu concentration, it can be indirectly checked that the perovskite structure 201 and the inorganic transition metal 205 form a one-to-one layer arrangement at a position circumscribing the octahedral structure of the unit forming the perovskite structure 201.

When the Eu concentration is 5 mM, values higher than the center value (0.35 V) of the potential level bar are sparsely present in the entire potential image and lack uniformity. However, in a partial region, it can also be checked that the perovskite structure 201 and the inorganic transition metal 205 form a one-to-one layer arrangement at a position circumscribing the octahedral structure of the unit forming the perovskite structure 201. On the other hand, when the Eu concentration is 10 mM, a value higher than the center value (0.35 V) of the potential level bar decreases, and the average potential level is lower than the average potential level when the Eu concentration is 7.5 mM, so that it can be checked that the perovskite structure 201 and the inorganic transition metal 205 do not properly form a one-to-one layer arrangement at a position circumscribing the octahedral structure of the unit forming the perovskite structure 201.

As described above, for the sample obtained by adjusting the amount of the inorganic transition metal different from the central metal contained in the perovskite structure, it can be checked whether or not the perovskite structure 201 and the inorganic transition metal 205 properly form a one-to-one layer arrangement by checking the texture display obtained by displaying a surface potential image overlaid with a surface shape image observed using a scanning probe microscope.

From the above test results, it could be verified that the photoelectric conversion element (photoelectric conversion device) of the present invention has an excellent response speed because the perovskite structure and the inorganic transition metal different from the central metal contained in the perovskite structure 201 form a one-to-one layer arrangement. In addition, an excellent hole collection effect (that is, more efficient collection) by the second layer was observed.

### [Industrial Applicability]

The photoelectric conversion element of the present disclosure has high efficiency and high sensitivity to a weak optical signal while reducing its environmental load, and thus has high industrial applicability.

### [Reference Signs List]

100 Photoelectric conversion element
101 Positive electrode layer
102 Negative electrode layer
103 Photoelectric conversion layer
104 First layer
105 Second layer
106 Third layer
107 Inorganic semiconductor layer
108 Organometallic complex layer
201 Perovskite structure
205 Second layer inorganic transition metal
206 Organic ligand
208 Organometallic complex

## Claims

1. A photoelectric conversion element, comprising, in the following order as a photoelectric conversion layer:
a first layer formed of a plurality of particles containing a perovskite structure as a main component, or an aggregate of the particles or a thin film containing the perovskite structure as a main component;
a second layer formed of a plurality of particles containing an inorganic transition metal as a main component, or an aggregate of the particles or a thin film containing an inorganic transition metal as a main component; and
a third layer formed of a plurality of particles containing an organic ligand as a main component, or an aggregate of the particles or a thin film containing an organic ligand as a main component, wherein
the inorganic transition metal in the second layer is different from a central metal contained in the perovskite structure,
at an interface between the first layer and the second layer, the perovskite structure and the inorganic transition metal in the second layer form a one-to-one layer arrangement, and
at an interface between the second layer and the third layer, the inorganic transition metal in the second layer and the organic ligand in the third layer are combined to form an organometallic complex layer made of an organometallic complex.

2. The photoelectric conversion element according to claim 1, wherein
in a conduction band, an energy level of LUMO of the conduction band of the organometallic complex layer is higher than an energy level of the conduction band of the first layer, and
in a valence band, an energy level of the valence band of the first layer is higher than an energy level of HOMO of the valence band of the organometallic complex layer.

3. The photoelectric conversion element according to claim 1, wherein the second layer is a layer formed by segregating the inorganic transition metal at a surface of the first layer.

4. The photoelectric conversion element according to claim 1, wherein the second layer is a monatomic layer of the inorganic transition metal.

5. The photoelectric conversion element according to claim 1, wherein the organic ligand is α-methylbenzylamine or terpyridine.

6. The photoelectric conversion element according to claim 5, wherein the central metal contained in the perovskite structure is lead, the inorganic transition metal in the second layer is europium, the inorganic transition metal in the second layer forming the organometallic complex is europium, and the organic ligand forming the organometallic complex is α-methylbenzylamine or terpyridine.

7. The photoelectric conversion element according to any one of claims 1 to 6, wherein the perovskite structure is a compound represented by formula CH₃NH₃PbI₃.

8. A photoelectric conversion device, comprising a photoelectric conversion element, wherein, in the photoelectric conversion element according to claim 1,
a negative electrode layer is laminated on a side opposite to the second layer with the first layer interposed therebetween, and
a positive electrode layer is laminated on a side opposite to the second layer with the third layer interposed therebetween.

9. A light detection method, comprising steps of:
allowing the photoelectric conversion layer to receive visible light and/or near-infrared light to cause a current to flow between the negative electrode layer and the positive electrode layer in the photoelectric conversion device according to claim 8; and
measuring the current to detect the visible light and/or the near-infrared light.

10. A method for producing a photoelectric conversion element, comprising:
a first step of coating a surface of a base material with a mixture containing a raw material of a perovskite structure and an inorganic transition metal that is contained in the raw material of the perovskite structure and is different from a central metal contained in the perovskite structure;
a second step of forming a first layer formed of a plurality of particles containing the perovskite structure as a main component or an aggregate of the particles or a thin film containing the perovskite structure as a main component and a second layer formed of a plurality of particles containing the inorganic transition metal as a main component or an aggregate of the particles or a thin film containing the inorganic transition metal as a main component by forming a one-to-one layer arrangement between the perovskite structure and the inorganic transition metal after the first step; and
a third step of forming an organometallic complex layer made of an organometallic complex by bonding an organic ligand to the inorganic transition metal through a coordinate bond at a second surface, which is opposite to a surface in contact with the first layer, of the second layer after the second step.

11. The method for producing a photoelectric conversion element according to claim 10, wherein
in a conduction band, an energy level of LUMO of the conduction band of the organometallic complex layer is higher than an energy level of the conduction band of the first layer, and
in a valence band, an energy level of the valence band of the first layer is higher than an energy level of HOMO of the valence band of the organometallic complex layer.

12. The method for producing a photoelectric conversion element according to claim 10, wherein in the second step, the second layer is formed at a surface of the first layer by segregating the inorganic transition metal.

13. The method for producing a photoelectric conversion element according to claim 10, wherein the second layer is a monatomic layer of the inorganic transition metal.

14. A method for producing a photoelectric conversion element, comprising:
a mixing step of mixing a raw material of a perovskite structure with an inorganic transition metal that is contained in the raw material of the perovskite structure and is different from a central metal contained in the perovskite structure to obtain a mixture;
a coating step of coating a surface of a base material with the mixture to form a coating layer;
a heating step of heating the coating layer after the coating step to form a first layer formed of a plurality of particles containing the perovskite structure as a main component or an aggregate the particles or a thin film containing the perovskite structure as a main component and a second layer formed of a plurality of particles containing the inorganic transition metal as a main component or an aggregate of the particles or a thin film containing the inorganic transition metal as a main component; and
a step of applying a solution containing an organic ligand to a surface, which is opposite to a surface in contact with the first layer, of the second layer after the heating step.
